# EUROPÄISCHE PATENTSCHRIFT

(11) **EP 1 560 306 B1**
(45) Veröffentlichungstag und Bekanntmachung des Hinweises auf die Patenterteilung: **19.11.2014**
(21) Anmeldenummer: 04029070.2
(22) Anmeldetag: 08.12.2004
(51) Int. Cl.: H01S 5/14, H01S 5/183

(54) **Oberflächenemittierender Halbleiterlaser mit einem Interferenzfilter**
VCSEL with optical filter
VCSEL avec filtre optique

(30) Priorität: 30.01.2004 DE 102004004776; 09.03.2004 DE 102004011456
(43) Veröffentlichungstag der Anmeldung: 03.08.2005
(73) Patentinhaber: OSRAM Opto Semiconductors GmbH, 93055 Regensburg (DE)
(72) Erfinder: Schwarz, Thomas, 93051 Regensburg (DE); Steegmüller, Ulrich, 93059 Regensburg (DE); Kühnelt, Michael, 93049 Regensburg (DE)
(74) Vertreter: Epping - Hermann - Fischer

(56) Entgegenhaltungen:
- WO-A-01/95445
- US-A- 6 167 068
- US-A1- 2003 012 230
- US-A1- 2003 231 666

## Beschreibung

Diese Patentanmeldung beansprucht die Priorität der deutschen Patentanmeldungen 102004011456.0 und 102004004776.6.

Die Erfindung betrifft einen oberflächenemittierenden Halbleiterlaser nach dem Oberbegriff des Patentanspruchs 1. Derartige oberflächenemittierende Halbleiterlaser sind auch unter den Begriffen Scheibenlaser, VECSEL (Vertical External Cavity Surface Emitting Laser) oder OPSL (Optically Pumped Semiconductor Laser) bekannt und werden beispielsweise in den Druckschriften WO 01/93386, WO 03/094311 und US 6,243,407 beschrieben.

Oberflächenemittierende Halbleiterlaser, die insbesondere im infraroten Spektralbereich eingesetzt werden, emittieren bei hohen Pumpleistungen spektral breitbandig in einem Wellenlängenbereich, der mehrere Nanometer breit sein kann. Oftmals ist daher eine Stabilisierung der Emissionswellenlänge und eine Kontrolle der spektralen Breite der Emission erforderlich. Dies ist insbesondere dann der Fall, wenn eine resonatorinterne Frequenzverdopplung vorgesehen ist.

In Bezug auf eine hohe Güte des Resonators und eine breitbandige Emission stellen Farbstofflaser oder Titan-Saphir-Laser dem Scheibenlaser vergleichbare Systeme dar. Bei diesen Lasern werden zur Kontrolle der spektralen Eigenschaften der Emission sogenannte Etalons und doppelbrechende Filter eingesetzt. Etalons beruhen auf dem Prinzip der Vielfachreflexion an planparallelen Plättchen und ermöglichen eine Abstimmung der Wellenlänge in einem begrenzten Bereich durch eine Variation des Einfallswinkels. Solche Etalons erfordern prinzipbedingt einen weitgehend parallelen Strahlverlauf.

Doppelbrechende Filter führen zu wellenlängen- und polarisationsabhängigen Verlusten und stabilisieren den Laser dadurch auf einer bevorzugten Wellenlänge. Sie eignen sich besonders für abstimmbare Laser, da die Wellenlänge des Lasers über eine azimutale Rotation des Filters in einem weiten Bereich einstellbar ist, ohne die sonstigen Resonatorverhältnisse zu beeinflussen.

Sowohl Etalons als auch doppelbrechende Filter sind für eine vergleichsweise verlustarme resonatorinterne Wellenlängenselektion geeignet. Allerdings erfordern sie ein Resonatordesign mit geringer Strahldivergenz und stellen hohe Anforderungen an die Justagegenauigkeit des Einfallswinkels beziehungsweise des Azimutwinkels.

Die Verwendung eines doppelbrechenden Filters zur Wellenlängenselektion bei einem Scheibenlaser ist aus der Patentschrift US 6,167,068 bekannt. In dieser Druckschrift wird auch eine resonatorinterne Wellenlängenkonversion des oberflächenemittierenden Halbleiterlasers beschrieben.

Der Patentschrift WO 01/95445 offenbart einen oberflächenemittierenden Halbleiterlaser gemäß dem Oberbegriff des Patentanspruchs 1.

Der Erfindung liegt die Aufgabe zugrunde, einen oberflächenemittierenden Halbleiterlaser mit einem verbesserten resonatorinternen Filter zur Stabilisierung der Emissionswellenlänge und zur Kontrolle der spektralen Breite der Emission anzugeben.

Diese Aufgabe wird gemäß der Erfindung durch einen oberflächenemittierenden Halbleiterlaser mit den Merkmalen des Patentanspruchs 1 gelöst. Vorteilhafte Ausgestaltungen und Weiterbildungen der Erfindung sind Gegenstand der abhängigen Ansprüche.

Bei einem oberflächenemittierenden Halbleiterlaser mit einem optisch oder elektrisch gepumpten strahlungsemittierenden Halbleiterchip, der einen ersten Resonatorspiegel enthält, und einem zweiten Resonatorspiegel, der außerhalb des Halbleiterchips angeordnet ist, wobei der erste Resonatorspiegel und der zweite Resonatorspiegel einen Laserresonator für die von dem Halbleiterchip emittierte Strahlung ausbilden, ist gemäß der Erfindung in dem Laserresonator ein Interferenzfilter enthalten, der aus einem Interferenzschichtsystem aus einer Mehrzahl dielektrischer Schichten gebildet ist.

Die Wellenlänge und die spektrale Breite der Laseremission können innerhalb des Verstärkungsspektrums des Lasers durch das Design und /oder den Einfallswinkel, unter dem die Laserstrahlung auf den Interferenzfilter trifft, variiert werden. Ein Interferenzfilter aus einem Interferenzschichtsystem aus einer Mehrzahl dielektrischer Schichten ist vergleichsweise kostengünstig herzustellen und kann vorteilhaft auf ein im Laserresonator vorhandenes Element aufgebracht sein. Dadurch wird der Herstellungs- und Justageaufwand reduziert. Die Anforderung an eine geringe Strahldivergenz ist im Vergleich zur Verwendung eines Etalons oder eines doppelbrechenden Filters reduziert.

Der Erfindung liegt die Erkenntnis zugrunde, dass die speziellen Eigenschaften des oberflächenemittierenden Halbleiterlasers, insbesondere das im Vergleich zu anderen abstimmbaren Lasersystemen mit einer Breite von etwa 10 nm bis 30 nm vergleichsweise schmalbandige Verstärkungsspektrum und seine empfindlichen Reaktion auf resonatorinterne Verluste, die Anwendung eines dielektrischen Interferenzfilters in einem derartigen Laser ermöglichen. Aufgrund dieser Eigenschaften kann bei der Auslegung des Filters eine vergleichsweise geringe Schmalbandigkeit und Seitenbandunterdrückung zugunsten geringerer Verluste in Kauf genommen werden. Im Gegensatz dazu werden gängige dielektrische Interferenzfilter aufgrund ihrer Charakteristik, insbesondere wegen der typischen maximalen Transmission von deutlich unter 99 %, bisher nicht in Laserresonatoren hoher Güte eingesetzt.

Der Interferenzfilter kann beispielsweise als Bandpassfilter, also als Transmissionsfilter, ausgeführt sein. In diesem Fall ist er vorteilhaft auf ein optisches Element aufgebracht, das in dem Laserresonator enthalten ist. Bei dem optischen Element handelt es sich zum Beispiel um eine Linse oder um einen optisch nicht-linearen Kristall zur Frequenzkonversion der Strahlung. Im Fall der Frequenzkonversion kann es sich um eine Frequenzvervielfachung, insbesondere eine Frequenzverdopplung handeln. Bei einem auf ein optisches Element aufgebrachten Bandpassfilter ist die gegenüberliegende Oberfläche des optischen Elements vorzugsweise mit einer Antireflexionsbeschichtung versehen, um die Transmission dieses Elements vorteilhaft zu erhöhen.

Alternativ zum Aufbringen des Bandpassfilters auf ein in dem Laserresonator enthaltenes optisches Element ist der Bandpassfilter, gemäß der vorliegenden Erfindung, auf eine Oberfläche des Halbleiterchips aufgebracht, durch die Strahlung aus dem Halbleiterchip emittiert wird.

In einer Variante dieser Ausführung der Erfindung weist der oberflächenemittierende Halbleiterlaser eine Pumpstrahlungsquelle auf, die außerhalb des Halbleiterchips angeordnet ist, und Pumpstrahlung in den Halbleiterchip einstrahlt, wobei der Bandpassfilter einen ersten Durchlassbereich für die Wellenlänge der Laserstrahlung und einen zweiten Durchlassbereich für die Wellenlänge der Pumpstrahlung aufweist. Die Pumpstrahlungsquelle des oberflächenemittierenden Halbleiterchips kann aber auch monolithisch auf dem Halbleiterchip integriert sein. In diesem Fall ist es nicht erforderlich, dass der Bandpassfilter einen Durchlassbereich für die Pumpstrahlung aufweist.

Die Transmission des Bandpassfilters ist bei der Wellenlänge der Laserstrahlung größer als 99,8 %.

In einer weiteren Anordnung, die nicht unter die vorliegende Erfindung fällt, ist der Interferenzfilter ein reflektierender Interferenzfilter, der im Gegensatz zu einem schmalen Transmissionsband, wie im Fall des Bandpassfilters, ein schmales Reflexionsband mit einer hohen Reflexion aufweist. Da der Laserresonator nur innerhalb dieses schmalen Reflexionsbands eine hohe Güte aufweist, wird die Emission von Laserstrahlung außerhalb des Reflexionsbands verhindert und auf diese Weise eine ähnliche Wirkung wie mit einem resonatorinternen Bandpassfilter erreicht. Insbesondere kann durch das Einstellen der Breite der Reflexionsbands der schmalbandigen Spiegels, das mit dem Fachmann bekannten Methoden des Schichtdesigns von Interferenzschichtsystemen erfolgt, eine Wellenlängenselektion oder -stabilisierung des Lasers erreicht werden.

Beispielsweise ist der zweite Resonatorspiegel als reflektierender Interferenzfilter ausgebildet. Der reflektierende Interferenzfilter weist im Bereich der Wellenlänge der Laserstrahlung bevorzugt eine Bandbreite von weniger als 10 nm auf, in der die Reflexion größer als 99% der maximalen Reflexion in diesem Bereich ist.

Der Laserresonator enthält zwischen dem ersten Resonatorspiegel und dem zweiten Resonatorspiegel beispielsweise einen Faltungsspiegel. Die Laserstrahlung wird in diesem Fall bevorzugt durch den Faltungsspiegel ausgekoppelt.

Bei einer weiteren Anordnung, die nicht unter die vorliegende Erfindung fällt, ist der Faltungsspiegel als reflektierender Interferenzfilter ausgebildet.

Der Laserresonator eines erfindungsgemäßen oberflächenemittierenden Halbleiterlasers kann einen nicht-linearen optischen Kristall zur Frequenzkonversion, insbesondere zu einer Frequenzvervielfachung wie zum Beispiel einer Frequenzverdopplung, enthalten, der vorzugsweise zwischen einem Faltungsspiegel und dem zweiten Resonatorspiegel angeordnet ist.

Die Wellenlänge der Laserstrahlung kann vorteilhaft durch eine Variation eines Einfallswinkels, unter dem die Strahlung auf den Interferenzfilter trifft, abgestimmt werden.
- Figur 1: eine schematische Darstellung eines oberflächenemittierenden Halbleiterlasers gemäß einer Beispielanordnung,
- Figur 2: eine schematische Darstellung eines oberflächenemittierenden Halbleiterlasers gemäß einer Beispielanordnung,
- Figur 3: eine schematische Darstellung eines optisch gepumpten Halbleiterlasers gemäß einer Beispielanordnung,
- Figur 4: eine schematische Darstellung eines oberflächenemittierenden Halbleiterlasers gemäß einem Ausführungsbeispiel der Erfindung,
- Figur 5: eine schematische Darstellung eines oberflächenemittierenden Halbleiterlasers gemäß einer Beispielanordnung,
- Figur 6: eine schematische Darstellung eines oberflächenemittierenden Halbleiterlasers gemäß einer Beispielanordnung, und
- Figur 7: eine schematische Darstellung eines oberflächenemittierenden Halbleiterlasers gemäß einer Beispielanordnung.

Gleiche oder gleichwirkende Elemente sind in den Figuren mit den gleichen Bezugszeichen versehen.

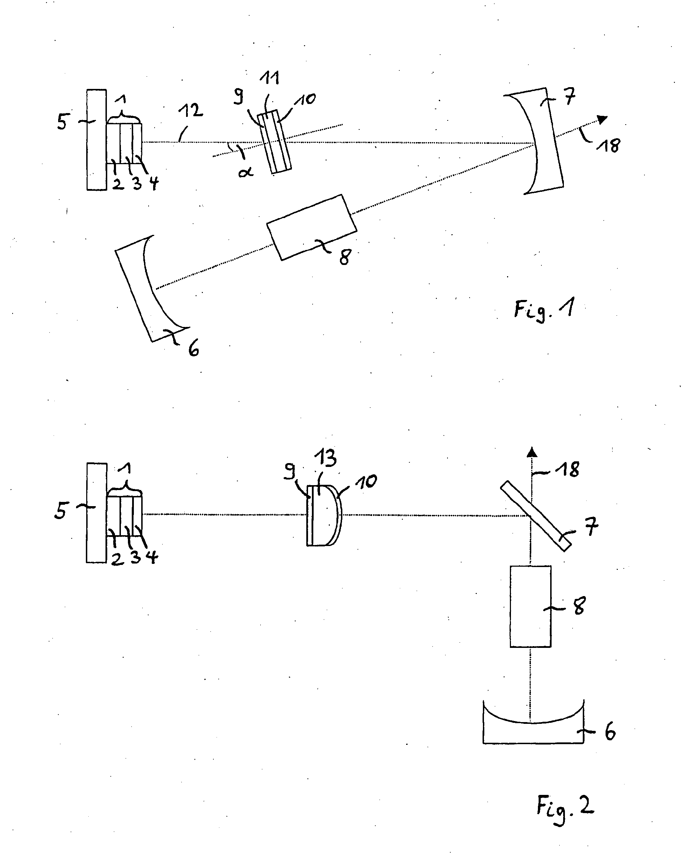

Der in Figur 1 dargestellte oberflächenemittierende Halbleiterlaser gemäß einer Anordnung, die nicht unter die vorliegende Erfindung fällt, enthält einen Halbleiterchip 1, der aus einer aktiven Zone 4 Strahlung 12 emittiert. Die aktive Zone 4 enthält zum Beispiel GaAs, AlGaAs, InGaAlP, InAlGaN oder eine andere III-V-Halbleiterverbindung.

Weiterhin enthält der Halbleiterchip 1 einen ersten Resonatorspiegel 3, bei dem es sich beispielsweise um einen epitaktisch auf einem Halbleitersubstrat 2 aufgewachsenen Bragg-Reflektor handeln kann. Weitere in dem Halbleiterchip 1 enthaltene Schichten, beispielsweise zur elektrischen Kontaktierung der aktiven Zone 4, sind in der vereinfachten Darstellung nicht abgebildet. Die Ausführung des Halbleiterchips 1 ist nicht auf eine bestimmte für oberflächenemittierende Halbleiterchips bekannte Schichtenfolge beschränkt, sondern kann vielmehr beliebig gewählt werden. Zum Beispiel können in dem Halbleiterchip 1 Pumplaser zum Pumpen der aktiven Zone 4 monolithisch integriert sein. Alternativ kann die aktive Zone auch durch eine Pumpstrahlungsquelle außerhalb des Halbleiterchips 1 oder durch Strominjektion elektrisch gepumpt sein. Der Halbleiterchip 1 ist beispielsweise auf einem Träger 5 montiert, bei dem es sich insbesondere um eine Wärmesenke handeln kann.

Der in dem Halbleiterchip 1 enthaltene erste Resonatorspiegel 3 bildet mit einem zweiten außerhalb des Halbleiterchips 1 angeordneten Resonatorspiegel 6 einen Laserresonator für die Laserstrahlung 12 aus. Der Laserresonator enthält in diesem Anordnung weiterhin einen Faltungsspiegel 7, wobei zwischen dem Faltungsspiegel 7 und dem zweiten Resonatorspiegel 6 ein optisch nicht-linearer Kristall 8 zur Frequenzkonversion der Laserstrahlung 12 enthalten ist. Der optisch nicht-lineare Kristall 8 bewirkt beispielsweise eine Frequenzverdopplung der Laserstrahlung. Insbesondere kann der Halbleiterchip 1 eine im infraroten Spektralbereich emittierende aktive Zone 4 enthalten und die infrarote Strahlung 12 mittels des optisch nicht-linearen Kristalls 8 in sichtbares oder ultraviolettes Licht 18 umgewandelt werden. Bevorzugt wird die frequenzkonvertierte Strahlung 18 durch den Faltungsspiegel 7 ausgekoppelt. In diesem Fall sollte der Faltungsspiegel 7 eine hohe Reflexion für die von dem Halbleiterchip emittierte Strahlung und einen hohe Transmission für die frequenzkonvertierte Strahlung 18 aufweisen. Auf diese Weise wird eine Rückkopplung der frequenzkonvertierten Strahlung 18 in den Halbleiterchip 1 verhindert.

Der Laserresonator enthält ein optisches Element 11, das in diesem Beispiel eine dünnes planparalleles Plättchen ist, wobei auf eine Oberfläche dieses optischen Elements 11 ein Bandpassfilter 9 aufgebracht ist, der aus einem Interferenzschichtsystem aus einer Mehrzahl dielektrischer Schichten gebildet ist. Durch den dielektrischen Bandpassfilter 9 werden die Wellenlänge und die spektrale Breite der emittierten Laserstrahlung 12 stabilisiert. Die Wellenlänge der Laserstrahlung 12 kann beispielsweise durch eine Variation des Einfallswinkels α, unter dem die Laserstrahlung 12 auf den Filter 9 trifft, abgestimmt werden.

Das Design des Bandpassfilters 9 erfolgt hinsichtlich der Auswahl der Schichtmaterialien, der Schichtdicken und der Abfolge der Schichten mit dem Fachmann bekannten Methoden. Dem Fachmann ist insbesondere bekannt, durch das Design der Schichtenfolge aus dielektrischen Schichten, die den Bandpassfilter 9 ausbildet, die spektrale Lage des Transmissionsmaximums, die spektrale Breite der Transmission und den Wert der maximalen Transmission zu beeinflussen.

Um die resonatorinternen Verluste zu minimieren, ist die dem Bandpassfilter 9 gegenüberliegende Oberfläche des optischen Elements 11 bevorzugt mit einer Antireflexionsbeschichtung 10 versehen.

Der Bandpassfilter 9 kann auf ein beliebiges im Laserresonator angeordnetes optisches Element aufgebracht sein. Bei dem in Figur 2 dargestellten Ausführungsbeispiel ist der Bandpassfilter 9 auf eine Linse 13 aufgebracht. Die dem Bandpassfilter 9 gegenüberliegende Seite der Linse 13 ist vorteilhaft mit einer Antireflexionsbeschichtung 10 versehen. Weiterhin unterscheidet sich die in Figur 2 dargestellte Anordnung von der in Figur 1 dargestellten dadurch, dass der Faltungsspiegel 7 um 45° gegen die Emissionsrichtung des Halbleiterchips geneigt ist und daher einen rechtwinklig gefalteten Resonator ausbildet.

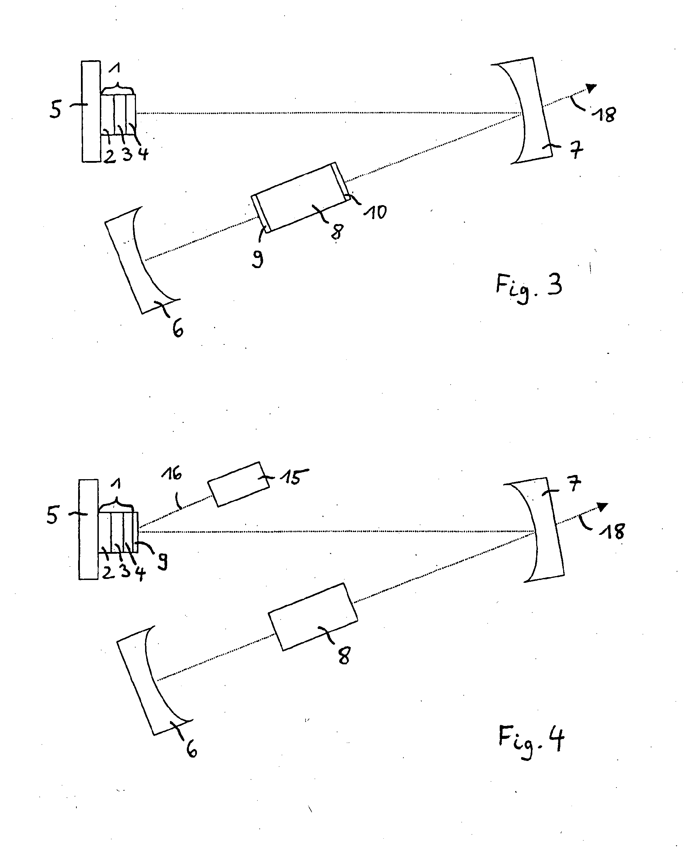

Eine weitere Möglichkeit zur Positionierung des Bandpassfilters 9 innerhalb des Laserresonators ist in Figur 3 dargestellt. In diesem Fall ist der Bandpassfilter 9 auf die Oberfläche eines nicht-linearen optischen Kristalls 8 aufgebracht, der zur Frequenzkonversion der Laserstrahlung dient. Die dem Bandpassfilter 9 gegenüberliegende Seite des nicht-linearen optischen Kristalls 8 ist bevorzugt mit einer Antireflexionsbeschichtung 10 versehen, die die Reflexion sowohl für die Laserstrahlung als auch für die frequenzkonvertierte Strahlung vermindert.

Alternativ kann ein Bandpassfilter 9, wie in Figur 4 dargestellt, auch auf die Oberfläche des Halbleiterchips 1, aus dem die Strahlung 12 emittiert wird, aufgebracht sein. Diese Ausführungsform der Erfindung ist insbesondere dann vorteilhaft, wenn sich keine zum Aufbringen des Bandpassfilters geeigneten optischen Elemente innerhalb des Laserresonators befinden oder wenn diese sich nur schwierig beschichten lassen. Beispielsweise lässt sich ein Bandpassfilter 9, der aus einem Interferenzschichtsystem dielektrischer Schichten gebildet ist, oftmals einfacher auf eine ebene Oberfläche des Halbleiterchips 1 aufbringen als auf eine gekrümmte Oberfläche eines optischen Elements.

Bei dem in Figur 4 gezeigten Ausführungsbeispiel der Erfindung wird Pumpstrahlung 16 von einer außerhalb des Halbleiterchips 1 angeordneten Pumpstrahlungsquelle 15 in die aktive Zone 4 des Halbleiterchips 1 eingestrahlt. Um das Eindringen der Pumpstrahlung 16 in den Halbleiterchip 1 zu ermöglichen, weist der Bandpassfilter 9 einen ersten Durchlassbereich bei der Wellenlänge der Laserstrahlung 12 und einen zweiten Durchlassbereich bei der Wellenlänge der Pumpstrahlung 16 auf.

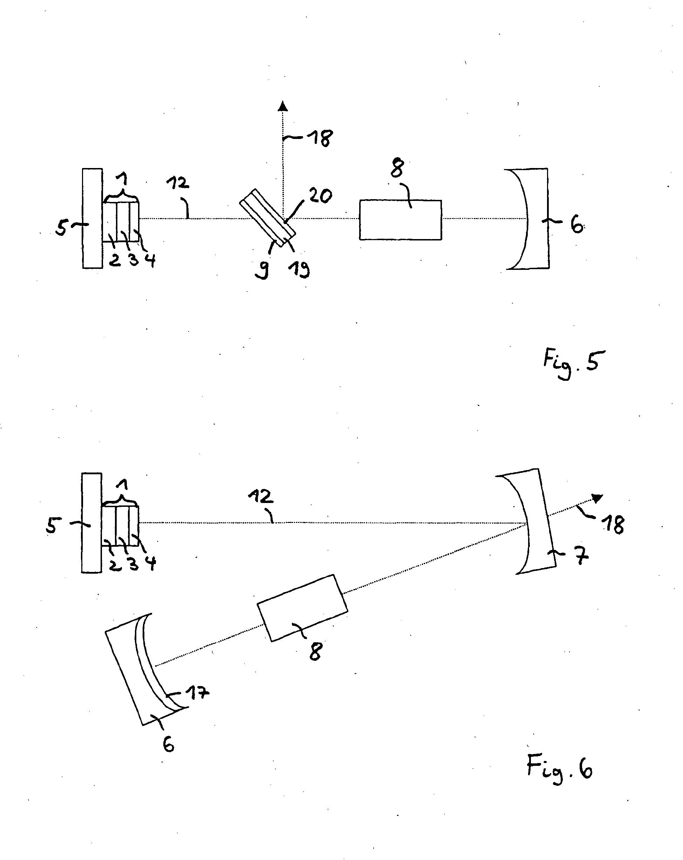

Die Anordnung in Fig. 5, die nicht unter die vorliegende Erfindung fällt, enthält einen optisch nicht-linearen Kristall 8 zur Frequenzkonversion der von dem Halbleiterchip 1 emittierten Strahlung 12 und einen Strahlteiler 19, bei dem auf einer dem Halbleiterchip 1 zugewandten Oberfläche der Bandpassfilter 9 aufgebracht ist. Auf der gegenüberliegenden, dem optisch nicht-linearen Kristall 8 zugewandten Oberfläche, ist der Strahlteiler 19 mit einer Beschichtung 20 versehen, die für die frequenzkonvertierte Strahlung 18 eine hohe Reflexion und für die von dem Halbleiterchip emittierte Strahlung 12 eine hohe Transmission aufweist. Auf diese Weise wird die frequenzkonvertierte Strahlung 18 aus dem Laserresonator ausgekoppelt, während die Strahlung 12 mit der Grundwellenlänge des Lasers im Resonator umläuft.

Bei der in Figur 6 dargestellten Anordnung, die nicht unter die vorliegende Erfindung fällt, ist der Interferenzfilter 17 als reflektierendes Interferenzschichtsystem 17 auf dem zweiten Resonatorspiegel 6 aufgebracht. Bevorzugt ist die Reflexion des schmalbandigen Spiegels 17 im Bereich der Wellenlänge der Laserstrahlung derart schmalbandig, dass sie nur innerhalb einer Bandbreite von weniger als 10 nm größer als 99% der maximalen Reflexion in diesem Bereich ist. Auch die in Figur 6 dargestellte Anordnung hat den Vorteil, dass der Interferenzfilter 17 auf eine ohnehin schon im Laserresonator vorhandene Komponente aufgebracht ist. Dadurch werden Absorptionsverluste, die bei der Verwendung eines doppelbrechenden Filters oder eines Etalons zur Wellenlängenselektion durch die Einbringung eines zusätzlichen Elements in den Laserresonator entstehen können, vorteilhaft vermindert.

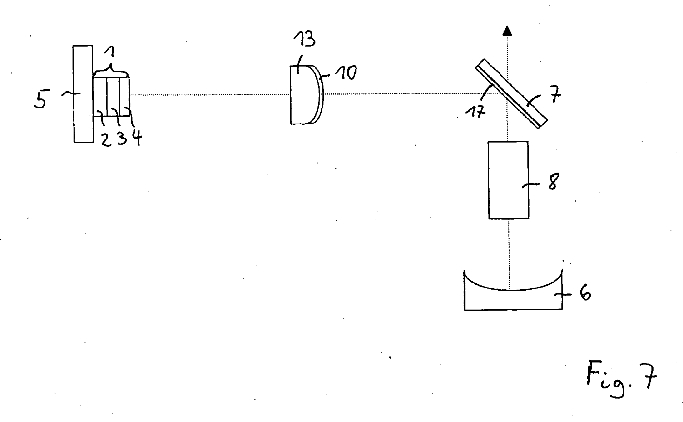

Weiterhin kann der Interferenzfilter, wie bei der in Fig. 7 dargestellten Anordnung, die nicht unter die vorliegende Erfindung fällt, ein reflektierender Interferenzfilter sein, der auf den Faltungsspiegel 7 aufgebracht ist. Der Faltungsspiegel 7 ist vorzugsweise um 45° gegen die Emissionsrichtung des Halbleiterchips geneigt, um einen rechtwinklig gefalteten Resonator auszubilden. Wie bei der in Fig. 2 dargestellten Anordnung die nicht unter die vorliegende Erfindung fällt wird die Laserstrahlung bevorzugt durch den Faltungsspiegel 7 aus dem Laserresonator ausgekoppelt. Der Laserresonator enthält vorteilhaft einen nicht-linearen optischen Kristalls 8, der zur Frequenzkonversion der Laserstrahlung dient. Zur Auskopplung der frequenzkonvertierten Strahlung weist der Faltungsspiegel bevorzugt eine hohe Transmission bei der Wellenlänge der frequenzkonvertierten Strahlung auf.

Der in dem Ausführungsbeispiel dargestellten oberflächenemittierenden Halbleiterlaser, der einen gefalteten Resonator und einen optisch nicht-linearen Kristall zur Frequenzkonversion der Laserstrahlung aufweist, ist eine bevorzugte Variante der Erfindung, die allerdings keine Einschränkung darstellt. Selbstverständlich ist die Erfindung auch für oberflächenemittierende Halbleiterlaser anwendbar, die keinen Faltungsspiegel aufweisen oder kompliziertere Resonatoraufbauten mit mehreren Faltungsspiegeln aufweisen. Ebenso vorteilhaft ist die Erfindung bei oberflächenemittierenden Halbleiterlasern, bei denen im Gegensatz zu den gezeigten Ausführungsbeispielen keine Frequenzkonversion der Strahlung vorgesehen ist.

Die Erfindung ist nicht durch die Beschreibung anhand des Ausführungsbeispiels beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispiel angegeben ist.

## Patentansprüche

1. Oberflächenemittierender Halbleiterlaser mit einem optisch oder elektrisch gepumpten Strahlung (12) emittierenden Halbleiterchip (1), der einen ersten Resonatorspiegel (3) enthält, und einem zweiten Resonatorspiegel (6), der außerhalb des Halbleiterchips (1) angeordnet ist, wobei der erste Resonatorspiegel (3) und der zweite Resonatorspiegel (6) einen Laserresonator für die von dem Halbleiterchip (1) emittierte Strahlung (12) ausbilden,
wobei der Laserresonator einen Interferenzfilter (9, 17) enthält, der aus einem Interferenzschichtsystem aus einer Mehrzahl dielektrischer Schichten gebildet ist und ein Bandpassfilter (9) ist,
**dadurch gekennzeichnet, dass**
der Bandpassfilter (9) auf eine Oberfläche des Halbleiterchips (1) aufgebracht ist, durch die Strahlung (12) aus dem Halbleiterchip (1) emittiert wird, wobei die Transmission des Bandpassfilters (9) bei der Wellenlänge der Laserstrahlung (12) größer als 99,8% ist.

2. Oberflächenemittierender Halbleiterlaser nach Anspruch 1, **dadurch gekennzeichnet, dass**
von einer Pumpstrahlungsquelle (15), die außerhalb des Halbleiterchips (1) angeordnet ist, Pumpstrahlung (16) in den Halbleiterchip (1) eingestrahlt wird, und der Bandpassfilter (9) einen ersten Durchlassbereich für die Wellenlänge der Laserstrahlung (12) und einen zweiten Durchlassbereich für die Wellenlänge der Pumpstrahlung (16) aufweist.

3. Oberflächenemittierender Halbleiterlaser nach Anspruch 1,
**dadurch gekennzeichnet, dass**
mindestens eine Pumpstrahlungsquelle monolithisch auf dem Halbleiterchip (1) integriert ist.

4. Oberflächenemittierender Halbleiterlaser nach einem der vorhergehenden Ansprüche,
**dadurch gekennzeichnet, dass**
der Laserresonator zwischen dem ersten Resonatorspiegel (3) und dem zweiten Resonatorspiegel (6) einen Faltungsspiegel (7) enthält.

5. Oberflächenemittierender Halbleiterlaser nach Anspruch 4,
**dadurch gekennzeichnet, dass**
die Laserstrahlung (12) durch den Faltungsspiegel (7) ausgekoppelt wird.

6. Oberflächenemittierender Halbleiterlaser nach einem der vorhergehenden Ansprüche,
**dadurch gekennzeichnet, dass**
ein optisch nichtlinearer Kristall (8) zur Frequenzkonversion der Strahlung (12) in dem Laserresonator enthalten ist.

7. Oberflächenemittierender Halbleiterlaser nach Anspruch 6,
**dadurch gekennzeichnet, dass**
die Frequenzkonversion eine Frequenzvervielfachung, insbesondere eine Frequenzverdopplung ist.

## Claims

1. Surface emitting semiconductor laser having a semiconductor chip (1) emitting radiation (12) which is optically or electrically pumped and contains a first resonator mirror (3),
and having a second resonator mirror (6) arranged outside the semiconductor chip (1), the first resonator mirror (3) and the second resonator mirror (6) forming a laser resonator for the radiation (12) emitted by the semiconductor chip (1),
the laser resonator containing an interference filter (9, 17), which is formed from an interference layer system comprising a plurality of dielectric layers and is a bandpass filter (9), **characterized in that**
the bandpass filter (9) is applied to a surface of the semiconductor chip (1) through which radiation (12) is emitted from the semiconductor chip (1), the transmission of the bandpass filter (9) being greater than 99.8% at the wavelength of the laser radiation (12).

2. Surface emitting semiconductor laser according to claim 1,
**characterized in that**
a pump radiation source (15) arranged outside the semiconductor chip (1) radiates pump radiation (16) into the semiconductor chip (1), and the bandpass filter (9) has a first passband for the wavelength of the laser radiation (12) and a second passband for the wavelength of the pump radiation (16).

3. Surface emitting semiconductor laser according to claim 1,
**characterized in that**
at least one pump radiation source is integrated monolithically on the semiconductor chip (1).

4. Surface emitting semiconductor laser according to one of the preceding claims,
**characterized in that**
the laser resonator contains a folding mirror (7) between the first resonator mirror (3) and the second resonator mirror (6).

5. Surface emitting semiconductor laser according to claim 4,
**characterized in that**
the laser radiation (12) is coupled out through the folding mirror (7).

6. Surface emitting semiconductor laser according to one of the preceding claims,
**characterized in that**
an optically nonlinear crystal (8) for frequency conversion of the radiation (12) is contained in the laser resonator.

7. Surface emitting semiconductor laser according to claim 6,
**characterized in that**
the frequency conversion is a frequency multiplication, in particular a frequency doubling.

## Revendications

1. Laser en semiconducteur à émission en surface, comprenant une puce en semiconducteur (1) émettant un rayonnement (12) pompé optiquement ou électriquement, laquelle contient un premier miroir résonateur (3), et un deuxième miroir résonateur (6) qui est disposé à l'extérieur de la puce en semiconducteur (1), le premier miroir résonateur (3) et le deuxième miroir résonateur (6) formant un résonateur laser pour le rayonnement (12) émis par la puce en semiconducteur (1),
le résonateur laser contenant un filtre à interférences (9, 17) qui est constitué d'un système de couches à interférences composé d'une pluralité de couches diélectriques et qui est un filtre passe-bande (9),
**caractérisé en ce que**
le filtre passe-bande (9) est appliqué sur une surface de la puce en semiconducteur (1) à travers laquelle le rayonnement (12) est émis hors de la puce en semiconducteur (1), la transmission du filtre passe-bande (9) à la longueur d'onde du rayonnement laser (12) étant supérieure à 99,8 %.

2. Laser en semiconducteur à émission en surface selon la revendication 1, **caractérisé en ce qu'**un rayonnement de pompage (16) est injecté dans la puce en semiconducteur (1) depuis une source de rayonnement de pompage (15) qui est disposée à l'extérieur de la puce en semiconducteur (1), et le filtre passe-bande (9) présente une première plage de passage pour la longueur d'onde du rayonnement laser (12) et une deuxième plage de passage pour la longueur d'onde du rayonnement de pompage (16).

3. Laser en semiconducteur à émission en surface selon la revendication 1, **caractérisé en ce qu'**au moins une source de rayonnement de pompage est intégrée de manière monolithique sur la puce en semiconducteur (1).

4. Laser en semiconducteur à émission en surface selon l'une des revendications précédentes, **caractérisé en ce que** le résonateur laser contient un miroir de convolution (7) entre le premier miroir résonateur (3) et le deuxième miroir résonateur (6).

5. Laser en semiconducteur à émission en surface selon la revendication 4, **caractérisé en ce que** le rayonnement laser (12) est découplé par le miroir de convolution (7).

6. Laser en semiconducteur à émission en surface selon l'une des revendications précédentes, **caractérisé en ce qu'**un cristal (8) non linéaire optiquement est contenu dans le résonateur laser pour la conversion de fréquence du rayonnement (12).

7. Laser en semiconducteur à émission en surface selon la revendication 6, **caractérisé en ce que** la conversion de fréquence est une multiplication de la fréquence, notamment un doublement de la fréquence.
